# EUROPEAN PATENT APPLICATION

(11) **EP 1 160 578 A1**
(43) Date of publication of application: **05.12.2001**
(21) Application number: 00304634.9
(22) Date of filing: 31.05.2000
(51) Int. Cl.: G01R 21/14, H03G 1/04

(54) **Method for standardizing a power detector**

(71) Applicant: LUCENT TECHNOLOGIES INC., Murray Hill, New Jersey 07974-0636 (US)
(72) Inventor: Eckl, Wolfgang Franz, 91080 Spardorf (DE)
(74) Representative: Watts, Christopher Malcolm Kelway, Dr.

(57) **Abstract**

The invention relates to a method for standardizing a power detector used in a transmitter stage.

The invention is providing a method for standardizing a power detector which permits an essentially temperature-independent standardization of the power detector.

For this purpose, a signal whose power level alternately changes at predefined times in such a way that the predefined power range is essentially completely passed through is initially applied to the input of the power detector. The output signal of the power detector is then evaluated in order to standardize it.

## Description

The invention relates to a method for standardizing a power detector which can preferably be used in a transmitter stage.

Such a power detector can be a component of a transmitter-stage power regulator which can be used to keep the output power of the transmitter stage constant.

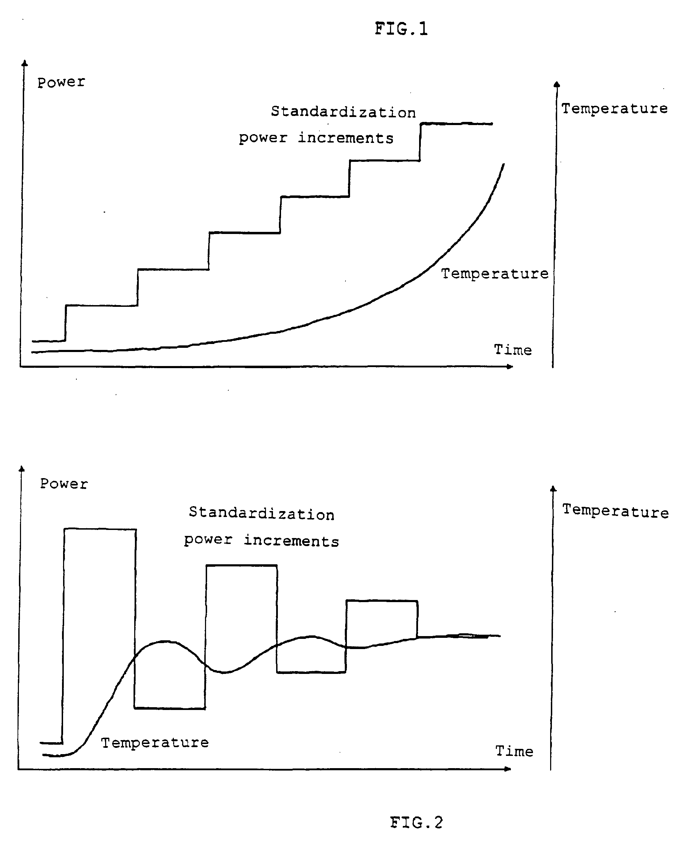

In order to ensure precise power measurement, the power detector is initially standardized by a defined power range, and the standardization should ideally be temperature-independent. However, in previous standardization methods the heat losses which usually occur in the transmitter stage during the power measurement cause the power detector to be influenced significantly by temperature. This is because previous standardization methods pass through the power range to be measured in a step shape from low power levels to high power levels, with the result that the heat losses of the transmitter stage also rise as the power increases, as is illustrated in Fig. 1.

The invention is therefore based on the object of making available a method for standardizing power detectors with which the power detector can be standardized in an essentially temperature-independent way.

This object is achieved by the invention having the method steps of Claim 1.

In order to be able to standardize the power detector independently of temperature within a predefined power range, a signal whose power level changes alternately at predefined times in such a way that the predefined power range is essentially completely passed through is initially applied to the input of the power detector. Because the temperature cannot follow the abrupt changes in the power level quickly enough during the standardization of the power detector with alternating power levels, the temperature oscillates to a medium value which is subjected to only slight fluctuations during the entire standardization phase. The output signal of the power detector is then evaluated in order to standardize the power detector.

Advantageous developments are the subject-matter of the subclaims.

One possible way of carrying out alternating standardization of the power detector provides that a process is initially started with the highest or the lowest power level of the predefined power range, the power levels then passing through the entire predefined power range during the measuring time.

A further possibility provides that the process begins with a medium power level with respect to the defined power range and that the process passes through the entire power range in the reverse direction, i.e. passes through the entire power range as far as the highest or, respectively, lowest power level.

An improved temperature characteristic, i.e. an essentially constant temperature profile of the transmitter stage is obtained during the measuring time if a pre-heating phase is carried out before the actual alternating standardization phase starts, during which pre-heating phase a medium power level with respect to the predefined power range is applied to the power detector for a predefined time. The temperature which is established during the pre-heating phase corresponds here essentially to the final value of the temperature which is reached during the alternating standardization phase.

The invention is explained in more detail below with reference to two exemplary embodiments in conjunction with the appended drawings, in which:
- Fig. 1: shows a timing diagram of the temperature profile and of the discrete power increments used for the standardization, in a conventional standardization method,
- Fig. 2: shows a timing diagram of the temperature profile and of the discrete power increments used for the standardization, in accordance with a method as in the invention, and
- Fig. 3: shows a timing diagram of the temperature profile and of the alternating power increments used for the standardization, in accordance with the method as in the invention, a pre-heating phase being carried out before the alternating standardization phase.

Fig. 2 shows the temperature profile which is plotted against the measurement time for a power detector which is to be standardized and is implemented in a transmitter stage, and the alternating power is increments which are applied to the power detector. As is clear from Fig. 2, the standardization starts at the highest power increment of a predefined power range over which the power detector is to be standardized. This power level is applied for a predefined time before the lowest power increment of the predefined power range is applied to the power detector. A power level is then applied to the power detector, which is lower than the previously applied highest power level by a predefined amount. Then, in turn, a power level is applied to the power detector which is higher than the previously applied lowest power level by a predefined amount. This alternating rhythm is continued over the entire power range until a medium power level with respect to the predefined power range is applied to the power detector at the end of the standardization phase. As Fig. 2 also shows, in contrast to the known standardization method which is illustrated in Fig. 1, the temperature does not follow the alternating power levels but rather oscillates essentially around a medium temperature range which corresponds to the final value of the temperature of the alternating standardization method.

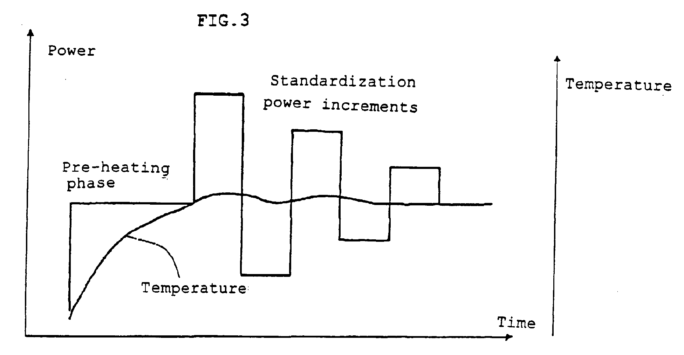

The harmonics in the temperature profile at the power detector can be reduced further if a so-called pre-heating phase is carried out for a predefined time period before the actual alternating standardization phase. During the pre-heating phase, a medium power level with respect to the predefined power range is applied to the power detector, the time being selected such that the temperature which is established in this case corresponds to the final value of the temperature during the following alternating standardization method. The alternating standardization method is not started until after it. As Fig. 3 shows, the temperature profile at the power detector is then virtually constant during the standardization phase.

The present temperature response of the power detector can also be corrected using a separate temperature compensation method which is not a subject-matter of the invention.

## Claims

1. Method for standardizing a power detector, used in a transmitter stage, within a predetermined power range having the following method steps:
a signal whose power levels change alternately at predefined times in such a way that the predefined power range is essentially completely passed through, is applied to the input of the power detector;
the output signal of the power detector is evaluated in order to standardize it.

2. Method according to Claim 1, **characterized in that** the predefined power range is alternately passed through starting with the highest or lowest power level.

3. Method according to Claim 1, **characterized in that** the predefined power range is alternately passed through up to the highest or lowest value starting at a medium power level.

4. Method according one of Claims 1 to 3, **characterized in that**, before the power levels are alternately changed, a predefined power level is initially applied for a predefined time.
